# EUROPÄISCHE PATENTANMELDUNG

(11) **EP 4 266 582 A1**
(43) Veröffentlichungstag der Anmeldung: **25.10.2023**
(21) Anmeldenummer: 23169000.9
(22) Anmeldetag: 20.04.2023
(51) Int. Cl.: H03K 17/975, H05K 1/00, H03K 17/96

(54) **SENSORMODUL**

(30) Priorität: 20.04.2022 DE 102022203854
(71) Anmelder: Witte Automotive GmbH, 42551 Velbert (DE)
(72) Erfinder: MENSCH, Reinaldo, 42113 Wuppertal (DE); HÖHN, Ralf, 42549 Velbert (DE)
(74) Vertreter: Liedtke & Partner Patentanwälte

(57) **Zusammenfassung**

Die Erfindung betrifft ein Sensormodul (1), umfassend:
- eine Sensoreinheit (2), die eine flächige Sensorelektrode (5) und eine flächige Schirmelektrode (6), die voneinander durch eine elastische, dielektrische Zwischenlage (7) beabstandet sind, und eine elastisch verformbare Blende (8) zur Abdeckung der Elektroden (5, 6) aufweist, und
- eine Elektronikeinheit (3),
wobei die Sensoreinheit (2) und die Elektronikeinheit (3) als separate Einheiten ausgebildet und durch elektrische Leiter miteinander elektrisch verbunden sind.

## Beschreibung

Die Erfindung betrifft ein Sensormodul zur Detektion einer Betätigung, beispielsweise durch einen Nutzer. Das Sensormodul kann an einem Bauteil, insbesondere einem Teil eines Fahrzeugs, angeordnet sein.

### Metal-Over-Cap-Sensoren (MOC) sind im Stand der Technik bekannt.

DE 10 2019 117 771 A1 beschreibt eine Griffanordnung für einen Verschluss eines Fahrzeugs, die einen kraftbasierten Sensor aufweist, der unter einer ununterbrochenen Klasse-A-Oberfläche angeordnet ist und auf eine darauf ausgeübte Kraft reagiert. Die Griffanordnung weist eine Griff-ECU auf, die ausgebildet ist, um den kraftbasierten Sensor zu überwachen und mit einem elektronischen Verriegelungscontroller zu kommunizieren. Ein Superkondensator ist auf einer PCB innerhalb der Griffanordnung angeordnet, um die Griff-ECU und den kraftbasierten Sensor mit elektrischer Energie zu versorgen. Die Griff-ECU weist eine oder mehrere Rückmeldevorrichtungen wie LED-Leuchten, akustische und haptische Vorrichtungen auf, um Informationen über den Status des Verschlusses und des elektronischen Verriegelungssystems bereitzustellen. Die Griffanordnung ist auch ausgebildet, um unterschiedliche Reaktionen auf zwei oder mehr verschiedene Kraftstufen bereitzustellen, die auf den kraftbasierten Sensor ausgeübt werden. Eine Ausgangsschnittstelle in der Griffanordnung stellt eine drahtgebundene und drahtlose Sicherungs-Kommunikation zum elektronischen Verriegelungscontroller bereit.

Aufgabe der vorliegenden Erfindung ist es, ein neuartiges Sensormodul anzugeben.

Die Aufgabe wird erfindungsgemäß gelöst mit einem Sensormodul, umfassend:
- eine Sensoreinheit, die eine flächige Sensorelektrode und eine flächige Schirmelektrode, die voneinander durch eine elastische, dielektrische Zwischenlage beabstandet sind, und eine elastisch verformbare Blende zur Abdeckung der Elektroden aufweist, und
- eine Elektronikeinheit,
wobei die Sensoreinheit und die Elektronikeinheit als separate Einheiten ausgebildet und durch elektrische Leiter miteinander elektrisch verbunden sind.

Die Zweiteilung des Sensormoduls in Sensoreinheit und Elektronikeinheit und die insbesondere flexible Verkabelung mittels elektrischer Leiter ermöglicht einen flexiblen Einbau in ein Bauteil, das insbesondere Teil eines Fahrzeugs sein kann, sowie eine besonders flache Bauweise der Sensoreinheit.

Somit kann die Sensoreinheit an nahezu beliebigen Stellen eines Fahrzeugs angebracht werden.

Durch die besonders kompakte Bauweise kann überall dort ein Sensor oder eine Sensoreinheit eingebaut werden, wo eine herkömmliche Integration aufgrund der Baugröße nicht möglich ist, beispielsweise hinter einem Verkleidungselement einer B-Säule oder C-Säule.

Die Betätigungsfläche kann wesentlich größer ausfallen als bei einem herkömmlichen Sensor, da die Elektroden insbesondere mittels einer leitfähigen Folie dargestellt werden und keiner Leiterplatte bedürfen. Die Betätigungsfläche kann beliebige Formen aufweisen, da die Folien in ihrer Form entsprechend angepasst werden können.

Beispielsweise kann die Sensoreinheit als ein Metal-Over-Cap-Sensor ausgebildet sein.

Die Zwischenlage kann beispielsweise aus einem Schaum oder einem Kunststoff gebildet sein.

Die Sensorelektrode und/oder die Schirmelektrode können/kann beispielsweise aus einer Metallfolie, insbesondere einer Kupferfolie, gebildet sein.

Die Schirmelektrode kann beispielsweise an der Blende befestigt, insbesondere aufgeklebt, sein.

Die Sensorelektrode und die Schirmelektrode können über einen jeweiligen elektrischen Leiter, insbesondere ein Kabel, mit der Elektronikeinheit elektrisch kontaktiert sein.

Die Kabel können beispielsweise als flexible Leitungen ausgebildet sein.

Die Elektronikeinheit kann dazu konfiguriert sein, eine elektrische Spannung an die Sensorelektrode und die Schirmelektrode anzulegen, so dass sich ein elektrisches Feld zwischen der Sensorelektrode und der Schirmelektrode ausbildet, wobei die Elektronikeinheit ferner dazu konfiguriert ist, Änderungen einer elektrischen Kapazität und/oder des elektrischen Feldes zwischen der Sensorelektrode und der Schirmelektrode zu detektieren.

Durch die Kontaktierung der beweglichen Schirmelektrode mit einem Controller, beispielsweise der Elektronikeinheit, kann eine wesentlich verbesserte Sensitivität des Sensormoduls erreicht werden, so dass mehr auswertbare Daten erzeugt werden.

Die elektrische Spannung kann beispielsweise eine Gleichspannung und/oder eine Wechselspannung sein.

Die Elektronikeinheit kann ein Gehäuse aufweisen, in dem eine elektrische Schaltung, umfassend eine Leiterplatte mit einer Anzahl von elektronischen Bauelementen, angeordnet ist, wobei die Kabel durch einen Durchgang im Gehäuse geführt und elektrisch mit der Leiterplatte kontaktiert sind.

Das Gehäuse kann darüber hinaus mit einem Verguss gefüllt sein.

In der Elektronikeinheit kann eine Schaltschwelle, insbesondere eine parametrierbare Schaltschwelle, für die elektrische Kapazität und/oder das elektrische Feld vorgesehen sein, wobei die Elektronikeinheit dazu konfiguriert ist, bei Überschreitung der Schaltschwelle ein Signal zu generieren. Das Signal kann an ein übergeordnetes Steuergerät, beispielsweise in einem Fahrzeug, an dem das Sensormodul angeordnet ist, gesendet werden und als Betätigung des Sensormoduls interpretiert werden.

Die Elektronikeinheit kann dazu konfiguriert sein, Alterungsgrößen, Klimagrößen, Seriengrößen und/oder weitere Einflussgrößen der Sensoreinheit zu kompensieren. Eine solche Einflussgröße kann beispielsweise eine Abstandsveränderung über die Lebensdauer infolge Nachlassens der Elastizität des Schaums und/oder des Materials der Blende sein.

Ferner kann an den an der Sensoreinheit angeschlossenen Kabeln eine Steckerkupplung angeordnet sein, wobei die Elektronikeinheit einen Stecker aufweist, der mit der Steckerkupplung elektrisch verbunden oder verbindbar ist. Alternativ kann an den Kabeln der Sensoreinheit ein Stecker und an der Elektronikeinheit eine damit elektrisch verbundene oder verbindbare Steckerkupplung angeordnet sein, wobei der Stecker oder die Steckerkupplung der Elektronikeinheit direkt oder über entsprechende Kabel mit der Leiterplatte elektrisch verbunden ist.

Im Durchgang kann ein Dichtelement angeordnet sein, das die elektrischen Kontakte des Steckers und der Steckerkupplung nach außen hin abdichtet, wenn diese miteinander verbunden sind.

Gemäß einem Aspekt der vorliegenden Erfindung wird ein Bauelement, insbesondere ein Fahrzeugblech, vorgeschlagen, wobei ein Sensormodul wie oben beschrieben an dem Bauelement angeordnet, insbesondere aufgeklebt, ist.

Die Blende kann dabei beispielsweise am Bauelement befestigt sein, beispielsweise angeklebt, angeschraubt und/oder mittels einer Clipverbindung befestigt.

Das Sensormodul kann auf einer Außenseite des Bauelements angeordnet sein, wobei die Kabel durch eine Durchführung im Bauelement zur Elektronikeinheit geführt sind, die auf der Innenseite des Bauelements angeordnet, beispielsweise befestigt, insbesondere angeklebt, angeschraubt und/oder mittels einer Clipverbindung befestigt, ist.

Die Durchführung kann im Bereich der Blende liegen und somit von dieser abgedeckt sein, so dass sie auf der Außenseite nicht sichtbar ist.

Alternativ kann die Elektronikeinheit an einem anderen Ort, beispielsweise weiter vom Bauelement entfernt angeordnet sein.

Der Stecker und/oder die Steckerkupplung können/kann beispielsweise in der Durchführung platziert sein.

Beispielsweise kann der Stecker auf einer der Innenseite zugewandten Seite des Gehäuses, in der der Durchgang vorgesehen sein kann, hinter oder in dem Durchgang im Inneren des Gehäuses angeordnet sein, so dass die elektrische Kontaktierung des Steckers mit der Steckerkupplung beim Anbringen der Elektronikeinheit am Bauelement erfolgt, wenn der Stecker mit der Steckerkupplung ausgerichtet ist.

Das Fahrzeugblech kann beispielsweise als eine Fahrzeugtür, eine Fronthaube, ein Heckdeckel oder eine Heckklappe ausgebildet sein.

Das Fahrzeugblech kann Teil eines Fahrzeugs sein. Dabei kann das Sensormodul beispielsweise hinter einer B-Säule oder C-Säule eingebaut sein.

Ausführungsbeispiele der Erfindung werden anhand von Zeichnungen näher erläutert. Dabei zeigen:
- Figur 1: eine schematische Ansicht eines Sensormoduls,
- Figur 2: eine schematische Ansicht des Sensormoduls während einer Betätigung, und
- Figur 3: eine schematische Ansicht einer weiteren Ausführungsform eines Sensormoduls während einer Betätigung.

Einander entsprechende Teile sind in allen Figuren mit den gleichen Bezugszeichen versehen.

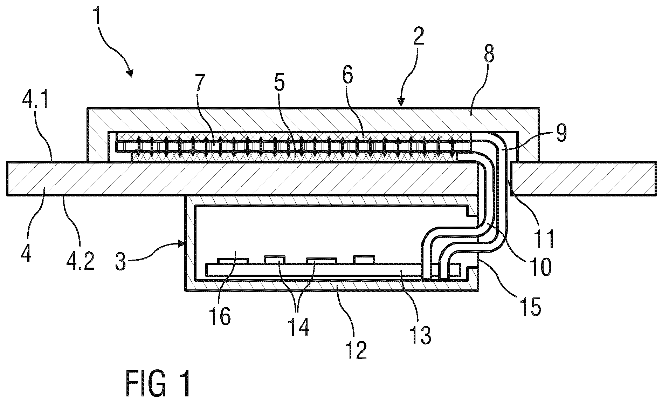

Figur 1 ist eine schematische Ansicht eines Sensormoduls 1, umfassend eine Sensoreinheit 2, die insbesondere als ein Metal-Over-Cap-Sensor (MOC) ausgebildet ist, und eine Elektronikeinheit 3. Die Sensoreinheit 2 und die Elektronikeinheit 3 können als separate Einheiten ausgebildet sein, so dass das Sensormodul 1 zweigeteilt ist. Das Sensormodul 1 oder die Sensoreinheit 2 kann an einem Bauelement 4 angeordnet sein. Das Bauelement 4 kann beispielsweise ein Fahrzeugblech sein, insbesondere eine Fahrzeugtür, eine Fronthaube oder ein Heckdeckel oder eine Heckklappe. In der in Figur 1 gezeigten Ausführungsform ist die Sensoreinheit 2 auf einer Außenseite 4.1 des Bauelements 4 angeordnet. Die Sensoreinheit 2 umfasst eine flächige Sensorelektrode 5 und eine flächige Schirmelektrode 6, die voneinander durch eine Zwischenlage 7, beispielsweise aus einem Schaum oder Kunststoff, insbesondere einem Dielektrikum, beabstandet sind. Auf diese Weise ergibt sich ein Sandwichaufbau der Sensorelektrode 5, der Zwischenlage 7 und der Schirmelektrode 6. Zwischen der Sensorelektrode 5 und der Schirmelektrode 6 kann durch Anlegen einer Spannung ein elektrisches Feld ausgebildet werden.

Die Sensorelektrode 5 und/oder die Schirmelektrode 6 können/kann beispielsweise als je eine isolierte Folie aus einem leitfähigen Material, beispielsweise einer Metallfolie, insbesondere Kupferfolie, ausgebildet sein. Die Sensorelektrode 5 kann am Bauelement 4 befestigt sein, beispielsweise aufgeklebt.

Die Sensoreinheit 2 kann ferner eine Blende 8 oder Kappe aufweisen, die den Sandwichaufbau der Sensorelektrode 5, der Zwischenlage 7 und der Schirmelektrode 6 abdeckt. Die Blende 8 kann aus einem Kunststoff gebildet sein, insbesondere einem flexiblen Kunststoff. Die Schirmelektrode 6 kann an der Blende 8 befestigt sein, beispielsweise aufgeklebt.

Die Blende 8 kann den Sandwichaufbau der Sensorelektrode 5, der Zwischenlage 7 und der Schirmelektrode 6 abgesehen von der am Bauelement 4 befestigten Seite der Sensorelektrode 5 umschließen. Dabei kann die Blende 8 am Bauelement 4 befestigt sein, beispielsweise angeklebt, angeschraubt und/oder mittels einer Clipverbindung befestigt.

Die Sensorelektrode 5 und die Schirmelektrode 6 sind mit einem jeweiligen elektrischen Leiter, beispielsweise einem Kabel 9, 10 elektrisch kontaktiert. Die Kabel 9, 10 können beispielsweise als flexible Leitungen ausgebildet sein. Die beiden Kabel 9, 10 können durch eine Durchführung 11 im Bauelement 4 zu dessen Innenseite 4.2 geführt sein. Die Durchführung 11 kann im Bereich der Blende 8 liegen und somit von dieser abgedeckt sein, so dass sie auf der Außenseite 4.1 nicht sichtbar ist.

Die Kabel 9, 10 sind durch die Durchführung 11 zur Elektronikeinheit 3 geführt und mit dieser elektrisch kontaktiert. Die Elektronikeinheit 3 kann auf der Innenseite 4.2 des Bauelements 4 angeordnet, beispielsweise befestigt, insbesondere angeklebt, angeschraubt und/oder mittels einer Clipverbindung befestigt, sein. Alternativ kann die Elektronikeinheit 3 an einem anderen Ort, beispielsweise weiter vom Bauelement 4 entfernt angeordnet sein.

Die Elektronikeinheit 3 weist beispielsweise ein Gehäuse 12 auf, in dem eine elektrische Schaltung, beispielsweise umfassend eine Leiterplatte 13 mit einer Anzahl von elektronischen Bauelementen 14, angeordnet ist. Die Kabel 9, 10 sind durch einen Durchgang 15 im Gehäuse 12 geführt und elektrisch mit der Leiterplatte 13 kontaktiert. Das Gehäuse 12 kann darüber hinaus mit einem Verguss 16 gefüllt sein.

Die Elektronikeinheit 3 ist dazu konfiguriert, eine elektrische Spannung, beispielsweise eine Gleichspannung und/oder eine Wechselspannung, an die Sensorelektrode 5 und die Schirmelektrode 6 anzulegen, so dass sich ein elektrisches Feld zwischen der Sensorelektrode 5 und der Schirmelektrode 6 ausbildet. Die Elektronikeinheit 3 ist ferner dazu konfiguriert Änderungen einer elektrischen Kapazität und/oder des elektrischen Feldes zwischen der Sensorelektrode 5 und der Schirmelektrode 6 zu detektieren.

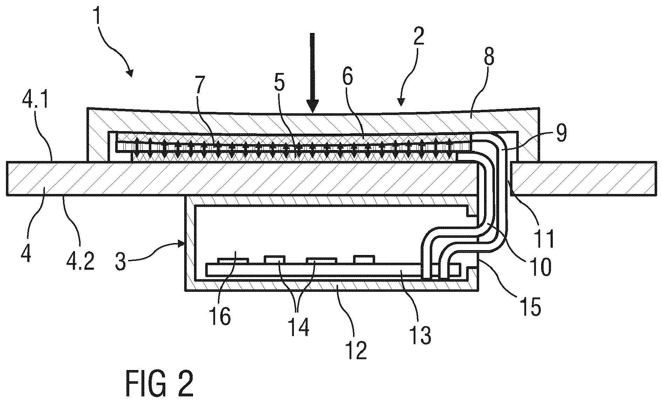

Figur 2 ist eine schematische Ansicht des Sensormoduls 1 während einer Betätigung, beispielsweise durch einen Nutzer. Zur Betätigung drückt der Nutzer auf die Blende 8, insbesondere etwa mittig. Die Blende 8 verformt sich dadurch im elastischen Bereich und bewegt die Schirmelektrode 6 in Richtung der Sensorelektrode 5 während die Zwischenlage 7 elastisch verformt und komprimiert wird. Da die Blende 8 nur im elastischen Bereich verformt wird, tritt keine Beschädigung der Blende 8 ein. Durch die Änderung des Abstands zwischen der Schirmelektrode 6 und der Sensorelektrode 5 und/oder durch die Änderung der dielektrischen Eigenschaften der Zwischenlage 7 infolge der Kompression ändert sich die elektrische Kapazität und/oder das elektrische Feld zwischen der Sensorelektrode 5 und der Schirmelektrode 6. Diese Änderung der elektrischen Kapazität und/oder des elektrischen Feldes wird von der Elektronikeinheit 3 detektiert. Dabei kann in der Elektronikeinheit 3 eine Schaltschwelle, insbesondere eine parametrierbare Schaltschwelle, für die elektrische Kapazität und/oder das elektrische Feld vorgesehen sein, bei deren Überschreitung die Elektronikeinheit 3 ein Signal generiert, das an ein übergeordnetes Steuergerät, beispielsweise in einem Fahrzeug, an dem das Sensormodul 1 angeordnet ist, gesendet werden und als Betätigung des Sensormoduls 1 interpretiert werden kann.

Wird die Betätigung beendet, das heißt nicht mehr auf die Blende 8 gedrückt, so stellt sich die Blende 8 in die in Figur 1 gezeigte Ausgangslage zurück. Dies kann durch den Schaum, der sich in der Zwischenlage 7 befindet oder aus dem diese besteht, unterstützt werden. Somit kehrt das elektrische Feld zwischen den Elektroden 5, 6 zu seinen Ursprungswerten zurück. Die Elektronikeinheit 3 wertet dies aus, detektiert, dass die Schaltschwelle unterschritten wurde und sendet kein Signal mehr an das übergeordnete Steuergerät. Die Elektronikeinheit 3 kann dazu konfiguriert sein, Alterungsgrößen, Klimagrößen, Seriengrößen und weitere Einflussgrößen der Sensoreinheit 2 zu kompensieren, beispielsweise eine Abstandsveränderung über die Lebensdauer infolge Nachlassens der Elastizität des Schaums und/oder des Materials der Blende 8.

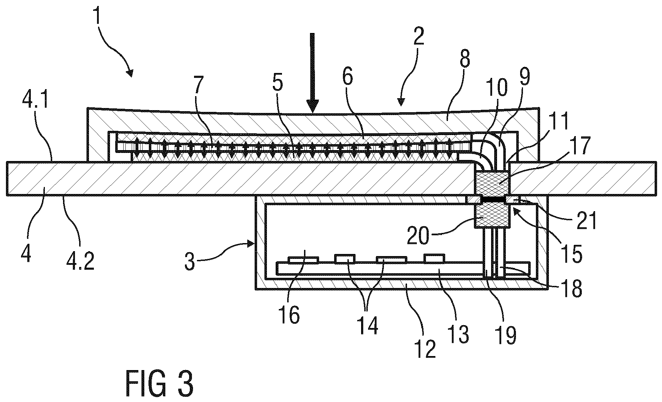

Figur 3 ist eine schematische Ansicht einer weiteren Ausführungsform eines Sensormoduls 1 während einer Betätigung.

Das Sensormodul 1 ist weitgehend übereinstimmend mit dem Sensormodul 1 gemäß den Figuren 1 und 2 aufgebaut. Zusätzlich ist jedoch an den an der Sensoreinheit 2 angeschlossenen Kabeln 9, 10 eine Steckerkupplung 17 angeordnet, die in der Durchführung 11 platziert sein kann. Die Elektronikeinheit 3 weist einen Stecker 20 auf, der mit der Steckerkupplung 17 elektrisch verbunden oder verbindbar ist.

Der Stecker 20 kann auf einer der Innenseite 4.2 zugewandten Seite des Gehäuses 12, in der der Durchgang 15 vorgesehen sein kann, hinter oder in dem Durchgang 15 im Inneren des Gehäuses 12 angeordnet sein, so dass die elektrische Kontaktierung des Steckers 20 mit der Steckerkupplung 17 beim Anbringen der Elektronikeinheit 3 am Bauelement 4 erfolgt, wenn der Stecker 20 mit der Steckerkupplung 17 ausgerichtet ist.

Im Durchgang 15 kann ein Dichtelement 21 angeordnet sein, dass die elektrischen Kontakte des Steckers 20 und der Steckerkupplung 17 nach außen hin abdichtet, wenn diese miteinander verbunden sind.

Alternativ kann an den Kabeln 9, 10 der Sensoreinheit 2 ein Stecker 20 und an der Elektronikeinheit 3 eine Steckerkupplung 17 angeordnet sein. Der Stecker 20 oder die Steckerkupplung 17 der Elektronikeinheit 3 kann direkt oder über entsprechende Kabel 18, 19 mit der Leiterplatte 13 elektrisch verbunden sein.

Die Zweiteilung des Sensormoduls 1 und die flexible Verkabelung ermöglicht einen flexiblen Einbau in das Bauteil 4, insbesondere in einem Fahrzeug, sowie eine besonders flache Bauweise der Sensoreinheit 2.

Somit kann die Sensoreinheit 2 an nahezu beliebigen Stellen eines Fahrzeugs angebracht werden.

Durch die besonders kompakte Bauweise kann überall dort ein Sensormodul 1 oder eine Sensoreinheit 2 eingebaut werden, wo eine herkömmliche Integration aufgrund der Baugröße nicht möglich ist, beispielsweise hinter einem Verkleidungselement einer B-Säule oder C-Säule.

Die Betätigungsfläche kann wesentlich größer ausfallen als bei einem herkömmlichen Sensor, da die Elektroden 5, 6 mittels der leitfähigen Folie dargestellt werden und keiner Leiterplatte bedürfen. Die Betätigungsfläche kann beliebige Formen aufweisen, da die Folien in ihrer Form entsprechend angepasst werden können.

Das in der Ausführungsform der Figur 3 dargestellte Direktstecksystem erlaubt eine besonders kostengünstige Kontaktierung und Montage.

### BEZUGSZEICHENLISTE

- 1: Sensormodul
- 2: Sensoreinheit
- 3: Elektronikeinheit
- 4: Bauelement
- 4.1: Außenseite
- 4.2: Innenseite
- 5: Elektrode, Sensorelektrode
- 6: Elektrode, Schirmelektrode
- 7: Zwischenlage
- 8: Blende
- 9: Kabel
- 10: Kabel
- 11: Durchführung
- 12: Gehäuse
- 13: Leiterplatte
- 14: elektronisches Bauelement
- 15: Durchgang
- 16: Verguss
- 17: Steckerkupplung
- 18: Kabel
- 19: Kabel
- 20: Stecker
- 21: Dichtelement

## Patentansprüche

1. Sensormodul (1), umfassend:
- eine Sensoreinheit (2), die eine flächige Sensorelektrode (5) und eine flächige Schirmelektrode (6), die voneinander durch eine elastische, dielektrische Zwischenlage (7) beabstandet sind, und eine elastisch verformbare Blende (8) zur Abdeckung der Elektroden (5, 6) aufweist, und
- eine Elektronikeinheit (3),
wobei die Sensoreinheit (2) und die Elektronikeinheit (3) als separate Einheiten ausgebildet und durch elektrische Leiter miteinander elektrisch verbunden sind.

2. Sensormodul (1) nach Anspruch 1, wobei die Sensorelektrode (5) und die Schirmelektrode (6) über einen jeweiligen elektrischen Leiter, insbesondere ein Kabel (9, 10), mit der Elektronikeinheit (3) elektrisch kontaktiert sind.

3. Sensormodul (1) nach Anspruch 1 oder 2, wobei die Elektronikeinheit (3) dazu konfiguriert ist, eine elektrische Spannung an die Sensorelektrode (5) und die Schirmelektrode (6) anzulegen, so dass sich ein elektrisches Feld zwischen der Sensorelektrode (5) und der Schirmelektrode (6) ausbildet, wobei die Elektronikeinheit (3) ferner dazu konfiguriert ist, Änderungen einer elektrischen Kapazität und/oder des elektrischen Feldes zwischen der Sensorelektrode (5) und der Schirmelektrode (6) zu detektieren.

4. Sensormodul (1) nach einem der Ansprüche 2 oder 3, wobei die Elektronikeinheit (3) ein Gehäuse (12) aufweist, in dem eine elektrische Schaltung, umfassend eine Leiterplatte (13) mit einer Anzahl von elektronischen Bauelementen (14), angeordnet ist, wobei die Kabel (9, 10) durch einen Durchgang (15) im Gehäuse (12) geführt und elektrisch mit der Leiterplatte (13) kontaktiert sind.

5. Sensormodul (1) nach einem der Ansprüche 3 oder 4, wobei in der Elektronikeinheit (3) eine Schaltschwelle, insbesondere eine parametrierbare Schaltschwelle, für die elektrische Kapazität und/oder das elektrische Feld vorgesehen ist, wobei die Elektronikeinheit (3) dazu konfiguriert ist, bei Überschreitung der Schaltschwelle ein Signal zu generieren.

6. Sensormodul (1) nach einem der vorhergehenden Ansprüche, wobei die Elektronikeinheit (3) dazu konfiguriert ist, Alterungsgrößen, Klimagrößen, Seriengrößen und weitere Einflussgrößen der Sensoreinheit (2) zu kompensieren.

7. Sensormodul (1) nach einem der Ansprüche 2 bis 6, wobei an den an der Sensoreinheit (2) angeschlossenen Kabeln (9, 10) eine Steckerkupplung (17) angeordnet ist, wobei die Elektronikeinheit (3) einen Stecker (20) aufweist, der mit der Steckerkupplung (17) elektrisch verbunden oder verbindbar ist, oder wobei an den Kabeln (9, 10) der Sensoreinheit (2) ein Stecker (20) und an der Elektronikeinheit (3) eine damit elektrisch verbundene oder verbindbare Steckerkupplung (17) angeordnet ist, wobei der Stecker (20) oder die Steckerkupplung (17) der Elektronikeinheit (3) direkt oder über entsprechende Kabel (18, 19) mit der Leiterplatte (13) elektrisch verbunden ist.

8. Sensormodul (1) nach Anspruch 7, wobei im Durchgang (15) ein Dichtelement (21) angeordnet ist, das die elektrischen Kontakte des Steckers (20) und der Steckerkupplung (17) nach außen hin abdichtet, wenn diese miteinander verbunden sind.

9. Bauelement (4), insbesondere Fahrzeugblech, wobei ein Sensormodul (1) nach einem der vorhergehenden Ansprüche an dem Bauelement (4) angeordnet,
insbesondere aufgeklebt, ist.

10. Bauelement (4) nach Anspruch 9, wobei das Sensormodul (1) auf einer Außenseite (4.1) des Bauelements (4) angeordnet ist, wobei die Kabel (9, 10) durch eine Durchführung (11) im Bauelement (4) zur Elektronikeinheit (3) geführt sind, die auf der Innenseite (4.2) des Bauelements (4) angeordnet, beispielsweise befestigt, insbesondere angeklebt, angeschraubt und/oder mittels einer Clipverbindung befestigt, ist.
